# EUROPEAN PATENT APPLICATION

(11) **EP 4 621 835 A1**
(43) Date of publication of application: **24.09.2025**
(21) Application number: 25155274.1
(22) Date of filing: 31.01.2025
(51) Int. Cl.: H01L 21/677, H01L 21/67

(54) **SUBSTRATE PROCESSING APPARATUS, METHOD FOR CONTROLLING SUBSTRATE PROCESSING APPARATUS, AND SUBSTRATE CONVEYANCE APPARATUS**

(30) Priority: 21.03.2024 JP 2024044940
(71) Applicant: SCREEN Holdings Co., Ltd., Kyoto-shi, Kyoto 602-8585 (JP)
(72) Inventor: KUWAHARA, Joji, Kyoto, 602-8585 (JP)
(74) Representative: Kilian Kilian & Partner mbB

(57) **Abstract**

The present invention relates to a substrate processing apparatus, a method for controlling the substrate processing apparatus, and a substrate conveyance apparatus. The substrate processing apparatus includes a conveyance robot including two hands and a controller. A support interval in an up-down direction between two support surfaces of the two hands is set to coincide with a placement interval in an up-down direction between two placement surfaces of two substrate placement tables. The controller causes a first hand to perform a first hand forward operation of moving forward, delivers a substrate to a first substrate placement table, and causes the first hand to perform a first hand backward operation of moving backward. The controller causes a second hand to perform a second hand forward operation of moving forward, receives a second substrate from a second substrate placement table, and causes the second hand to perform a second hand backward operation of moving backward. The controller causes the first hand and the second hand to perform the first hand backward operation and the second hand forward operation in parallel.

## Description

### Technical Field

The present invention relates to a substrate processing apparatus that processes a substrate, a method for controlling the substrate processing apparatus, and a substrate conveyance apparatus. Examples of the substrate includes a semiconductor substrate, a substrate for a flat panel display (FPD), a glass substrate for a photomask, a substrate for an optical disk, a substrate for a magneto-optical disk, a ceramic substrate, and substrate for a solar cell. Examples of the FPD include a liquid crystal display device and an organic electroluminescence (EL) display device.

### Background Art

A substrate processing apparatus includes a coating processing block, a development processing block, and an interface block disposed in a horizontal direction in one row (see, for example, JP 2009-010291 A). Each of the coating processing block, the development processing block, and the interface block includes a substrate conveyance robot. For example, a placement table (placement unit) is provided between the coating processing block and the development processing block. The placement table is used for conveying a substrate between a first substrate conveyance robot of the coating processing block and a second substrate conveyance robot of the development processing block.

For example, three pins are provided on the upper surface of the placement table (see, for example, JP 2020-053428 A). The substrate conveyance robot includes two hands provided one above the other (see, for example, JP 2019-068057 A).

### SUMMARY

The conventional substrate conveyance robot places a first substrate onto a placement table for sending and receives a second substrate from a placement table for return as follows. It is assumed that the lower hand currently holds the first substrate and the upper hand does not hold the second substrate.

First, the substrate conveyance robot moves forward the lower hand, places the first substrate onto the placement table for sending with the lower hand, and moves backward the lower hand that does not support the first substrate. Thereafter, the substrate conveyance robot raises the upper hand to a preset height position to receive the second substrate from the placement table for return. Thereafter, the substrate conveyance robot moves forward the upper hand, receives the second substrate from the placement table for return with the upper hand, and moves backward the upper hand holding the second substrate.

However, such an operation may take time. Thus, there is a case where the efficiency of conveying substrates does not satisfy the user's demand.

The present invention has been made in view of such circumstances, and an object thereof is to provide a substrate processing apparatus, a method for controlling the substrate processing apparatus, and a substrate conveyance apparatus that can improve the efficiency of conveying substrates.

To achieve such an object, the present invention has the following configurations. That is, a substrate processing apparatus that processes a substrate according to the present invention includes a first substrate conveyance robot including a first hand and a second hand disposed one above the other, the first substrate conveyance robot being capable of delivering and receiving a substrate to and from a first placement table and a second placement table disposed one above the other by moving the first hand and the second hand; and a controller, wherein the first hand is configured to support one first substrate in a horizontal orientation, the second hand is configured to support one second substrate in the horizontal orientation, a support interval in an up-down direction between a substrate support surface of the first hand and a substrate support surface of the second hand is set to coincide with a placement interval in an up-down direction between a placement surface of the first placement table on which the substrate is to be placed and a placement surface of the second placement table on which the substrate is to be placed, the controller: causes the first hand supporting the first substrate to perform a first hand forward operation of moving forward toward the first placement table; delivers the first substrate to the first placement table with the first hand by causing the first hand and the first placement table to move up and down with respect to each other; thereafter, causes the first hand to perform a first hand backward operation of moving backward from the first placement table; causes the second hand to perform a second hand forward operation of moving forward toward the second placement table; receives the second substrate from the second placement table with the second hand by causing the second hand and the second placement table to move up and down with respect to each other; and thereafter, causes the second hand to perform a second hand backward operation of moving backward from the second placement table, and the controller causes the first hand and the second hand to perform either: the first hand backward operation and the second hand forward operation in parallel; or the first hand forward operation and the second hand backward operation in parallel.

According to the substrate processing apparatus of the present invention, the support interval in an up-down direction between the two support surfaces of the first hand and the second hand is set to coincide with the placement interval in an up-down direction between the two placement surfaces of the first placement table and the second placement table. For example, the first hand backward operation of moving backward the first hand after placing the first substrate onto the first placement table and the second hand forward operation of moving forward the second hand to receive the second substrate from the second placement table are performed in parallel. This can shorten the total time from the start of the first hand backward operation to the end of the second hand forward operation. Thus, the efficiency of conveying substrates can improve.

The substrate processing apparatus described above preferably further includes a processing block that individually performs preset processing on a plurality of substrates; and an interface block that performs loading and unloading of the substrates into and from an external device, the interface block being coupled to the processing block, wherein the first substrate conveyance robot is preferably provided in the interface block, and the first substrate conveyance robot preferably delivers and receives the substrates to and from the first placement table and the second placement table provided in the external device.

In recent years, the processing efficiency of an external device has been improved. Thus, there is a possibility that the external device waits for the conveyance of the substrate performed by the interface block. Thus, for example, it is conceivable to increase the number of substrate conveyance robots for conveying the substrate to the external device and for conveying the substrate from the external device. However, this is not preferable from the viewpoint of cost and space. According to the present invention, the support interval between the first hand and the second hand of the substrate conveyance robot of the interface block is set to coincide with the placement interval between the first placement table and the second placement table of the external device. Thus, the efficiency of conveying substrates performed by the conveyance robot of the interface block can improve. As a result, the occurrence of a situation in which the external device waits for the conveyance of the substrate performed by the interface block can be prevented.

In the substrate processing apparatus described above, an example of the external device is an exposure device. The occurrence of a situation in which the exposure device waits for the conveyance of the substrate performed by the interface block can be prevented.

In the substrate processing apparatus described above, the controller causes, as an example, the first hand and the second hand to perform the first hand backward operation and the second hand forward operation in parallel. This makes it possible to improve the efficiency of conveying substrates in a series of operations of delivering the first substrate to the first placement table then taking a substrate from the second placement table.

It is preferable that the substrate processing apparatus described above further includes a first processing block that individually performs preset first processing on a plurality of substrates; a second processing block that individually performs preset second processing on the plurality of substrates; the first placement table and the second placement table provided one above the other at a boundary between the first processing block and the second processing block; and a second substrate conveyance robot including a third hand and a fourth hand disposed one above the other, the second substrate conveyance robot delivering and receiving a substrate to and from the first placement table and the second placement table by moving the third hand and the fourth hand, wherein the first substrate conveyance robot is provided in the first processing block, the second conveyance robot is provided in the second processing block, the third hand is configured to support the first substrate in a horizontal orientation, the fourth hand is configured to support one third substrate in a horizontal orientation, and a second support interval in an up-down direction between a substrate support surface of the third hand and a substrate support surface of the fourth hand is set to coincide with the placement interval in an up-down direction between the placement surface of the first placement table on which a substrate is to be placed and the placement surface of the second placement table on which a substrate is to be placed, the controller: causes the third hand to perform a third hand forward operation of moving forward toward the first placement table; receives the first substrate from the first placement table with the third hand by causing the third hand and the first placement table to move up and down with respect to each other; and thereafter, causes the third hand to perform a third hand backward operation of moving backward from the first placement table; causes the fourth hand supporting the third substrate to perform a fourth hand forward operation of moving forward toward the second placement table; delivers the third substrate to the second placement table with the fourth hand by causing the fourth hand and the second placement table to move up and down with respect to each other; and thereafter, causes the fourth hand to perform a fourth hand backward operation of moving backward from the second placement table, and the controller causes the third hand and the fourth hand to perform either: the third hand backward operation and the fourth hand forward operation in parallel; or the fourth hand backward operation and the third hand forward operation in parallel.

The first placement table and the second placement table are provided the boundary between the first processing block and the second processing block. The first substrate conveyance robot of the first processing block and the second substrate conveyance robot of the second processing block access the first placement table and the second placement table. Thus, the efficiency of conveying the substrates performed by both the first substrate conveyance robot and the second substrate conveyance robot placed via the first placement table and the second placement table can improve.

In a method for controlling a substrate processing apparatus that processes a substrate according to the present invention, the substrate processing apparatus includes a first substrate conveyance robot including a first hand and a second hand disposed one above the other, the first substrate conveyance robot being capable of delivering and receiving a substrate to and from a first placement table and a second placement table disposed one above the other by moving the first hand and the second hand, wherein the first hand is configured to support one first substrate in a horizontal orientation, the second hand is configured to support one second substrate in the horizontal orientation, a support interval in an up-down direction between a substrate support surface of the first hand and a substrate support surface of the second hand is set to coincide with a placement interval in an up-down direction between a placement surface of the first placement table on which the substrate is to be placed and a placement surface of the second placement table on which the substrate is to be placed, the method including: a first hand forward step of causing the first hand supporting the first substrate to move forward toward the first placement table; a first placement step of delivering the first substrate to the first placement table with the first hand by causing the first hand and the first placement table to move up and down with respect to each other; after the first placement step, a first hand backward step of causing the first hand to move backward from the first placement table; a second hand forward step of causing the second hand to move forward toward the second placement table; a first reception step of receiving the second substrate from the second placement table with the second hand by causing the second hand and the second placement table to move up and down with respect to each other; and after the first reception step, a second hand backward step of causing the second hand supporting the second substrate to move backward from the second placement table, wherein the first hand backward step and the second hand forward step are performed in parallel, or the first hand forward step and the second hand backward step are performed in parallel.

A substrate conveyance apparatus that conveys a substrate according to the present invention includes a first substrate conveyance robot including a first hand and a second hand disposed one above the other, the first substrate conveyance robot being capable of delivering and receiving a substrate to and from a first placement table and a second placement table disposed one above the other by moving the first hand and the second hand; and a controller, wherein the first hand is configured to support one first substrate in a horizontal orientation, the second hand is configured to support one second substrate in the horizontal orientation, a support interval in an up-down direction between a substrate support surface of the first hand and a substrate support surface of the second hand is set to coincide with a placement interval in an up-down direction between a placement surface of the first placement table on which the substrate is to be placed and a placement surface of the second placement table on which the substrate is to be placed, the controller: causes the first hand supporting the first substrate to perform a first hand forward operation of moving forward toward the first placement table; delivers the first substrate to the first placement table with the first hand by causing the first hand and the first placement table to move up and down with respect to each other; thereafter, causes the first hand to perform a first hand backward operation of moving backward from the first placement table; causes the second hand to perform a second hand forward operation of moving forward toward the second placement table; receives the second substrate from the second placement table with the second hand by causing the second hand and the second placement table to move up and down with respect to each other; and thereafter, causes the second hand to perform a second hand backward operation of moving backward from the second placement table, and the controller causes the first hand and the second hand to perform either: the first hand backward operation and the second hand forward operation in parallel; or the first hand forward operation and the second hand backward operation in parallel.

The substrate processing apparatus, the method for controlling the substrate processing apparatus, and the substrate conveyance apparatus according to the present invention can improve the efficiency of conveying substrates.

### BRIEF DESCRIPTION OF DRAWINGS

Fig. 1 is a plan view illustrating a substrate processing apparatus according to an embodiment.
Fig. 2 is a longitudinal sectional view illustrating the substrate processing apparatus according to the embodiment.
Fig. 3 is a longitudinal sectional view of an interface block when viewed as indicated by the arrow Q in Fig. 1.
Fig. 4 is a side view illustrating two conveyance robots and two substrate placement tables.
Fig. 5 is a plan view illustrating two hands and a reciprocating unit of each conveyance robot of a coating processing block and a development processing block.
Fig. 6 is a plan view illustrating a conveyance robot of the interface block.
Fig. 7 is a side view illustrating the conveyance robot of the interface block and two substrate placement table of an exposure device.
Fig. 8 is a flowchart for describing an operation of the substrate processing apparatus.
Figs. 9A to 9D are diagrams for describing an operation of a conveyance robot.
Figs. 10A to 10C are side views for describing an operation of the conveyance robot of the coating processing block.
Figs. 11A to 11C are side views for describing an operation of the conveyance robot of the coating processing block.
Figs. 12A to 12C are side views for describing an operation of the conveyance robot of the development processing block.
Figs. 13A to 13C are side views for describing an operation of the conveyance robot of the development processing block.
Figs. 14A to 14C are side views for describing an operation of the conveyance robot of the interface block.
Figs. 15A to 15C are side views for describing an operation of the conveyance robot of the interface block.
Fig. 16 is a diagram for describing an effect of the embodiment.

### DETAILED DESCRIPTION

Hereinafter, an embodiment of the present invention will be described.

### Embodiment

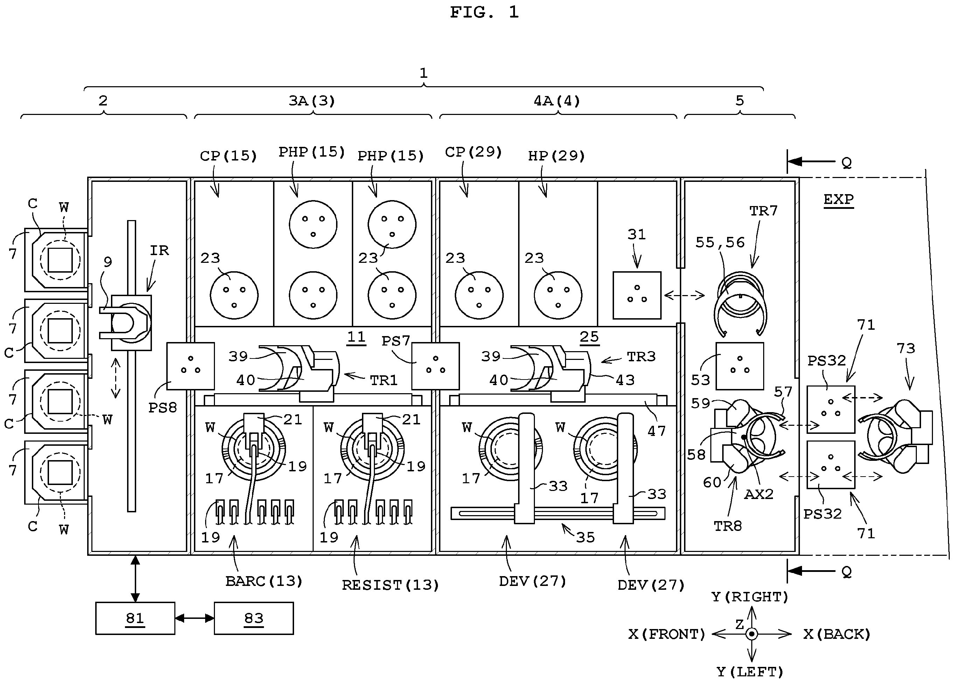

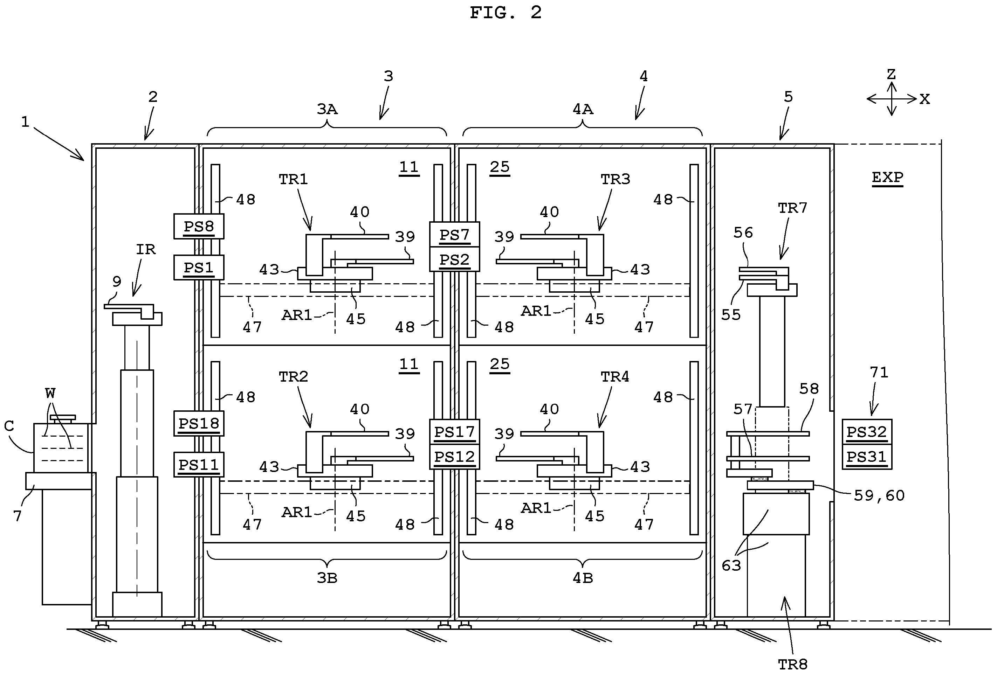

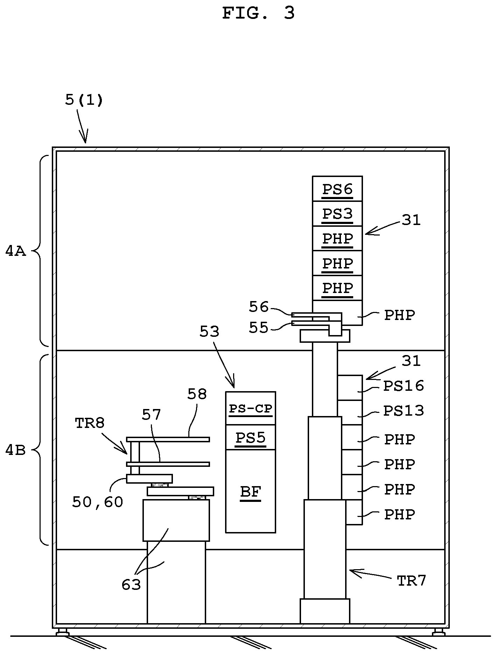

Hereinafter, an embodiment of the present invention will be described with reference to the drawings. Fig. 1 is a plan view illustrating a substrate processing apparatus 1 according to the embodiment. Fig. 2 is a longitudinal sectional view illustrating the substrate processing apparatus 1. Fig. 3 is a longitudinal sectional view of an interface block 5 when viewed as indicated by the arrow Q in Fig. 1.

In the present specification, for convenience, the directions in which the coating processing block 3 and the development processing block 4 are arranged are referred to as "front-back directions X". The front-back directions X are horizontal. Of the front-back directions X, for example, the direction from the development processing block 4 toward the coating processing block 3 is referred to as "front direction". The direction opposite to the front direction is referred to as "back direction". The horizontal directions orthogonal to the front-back directions X are referred to as "width directions Y". One direction in the "width directions Y" is appropriately referred to as "right direction". The direction opposite to the right direction is referred to as "left direction". The directions perpendicular to the horizontal directions are referred to as "vertical directions Z". In each drawing, front, back, right, left, top, and bottom are appropriately shown for reference.

### <1. Configuration of Substrate Processing Apparatus>

See Figs. 1 and 2. The substrate processing apparatus 1 processes a substrate. The substrate processing apparatus 1 forms a resist film on a substrate W and develops the exposed substrate W. The substrate processing apparatus 1 includes an indexer block 2, a coating processing block 3, a development processing block 4, and an interface block 5.

The indexer block 2, the coating processing block 3, the development processing block 4, and the interface block 5 are disposed in one row in the back direction (front-back directions X) in this order. An exposure device EXP is provided adjacent to the interface block 5 as an external device. The exposure device EXP is a device outside the substrate processing apparatus 1.

The coating processing block 3 corresponds to a first processing block and a processing block of the present invention. The development processing block 4 corresponds to a second processing block and a processing block of the present invention.

### <1-1. Configuration of Indexer Block>

For example, four carrier placement shelves 7 are provided on the front surface of the indexer block 2. The four carrier placement shelves 7 are disposed in the width directions Y. A carrier C is placed on each of the four carrier placement shelves 7. A plurality of (for example, 25) substrates W aligned at a preset interval (for example, 10 mm) are stored in the carrier C. As the carrier C, for example, a front open unified pod (FOUP) is used, but the carrier C is not limited to this configuration. Each substrate is, for example, a circular substrate having a diameter of 300 mm. The substrate is referred to as "substrate W" unless otherwise distinguished.

The indexer block 2 includes an indexer robot IR. The indexer robot IR includes a hand 9 that supports one substrate W in a horizontal orientation. The indexer robot IR moves the hand 9 in the horizontal directions (the front-back directions X and the width directions Y) and the vertical direction Z, and rotates the hand 9 about a vertical axis. The indexer robot IR conveys the substrate W between the four carriers C placed on the four carrier placement shelves 7 and four substrate placement tables PS1, PS8, PS11, and PS18 described later. The indexer robot IR is driven by an electric motor.

### <1-2. Configuration of Coating Processing Block>

The coating processing block 3 individually performs preset coating processing (first processing) on a plurality of (for example, 25) substrates W. The coating processing block 3 is coupled to the indexer block 2. In other words, the coating processing block 3 is disposed to be adjacent to the back side of the indexer block 2. The coating processing block 3 includes a coating processing layer 3A and a coating processing layer 3B stacked in the vertical directions Z. The coating processing layer 3A is disposed on the upper side of the coating processing layer 3B.

Each of the two coating processing layers 3A and 3B includes a conveyance space 11, a plurality of liquid processing units 13, a plurality of processing units 15, and a conveyance robot TR1 (TR2). The coating processing layer 3B has substantially the same configuration as the coating processing layer 3A. Thus, the configuration of the upper coating processing layer 3A will be described as a representative.

As illustrated in Fig. 1, the conveyance space 11 extends in the front-back directions X. The plurality of liquid processing units 13 and the plurality of processing units 15 are disposed in the front-back directions X in which the conveyance space 11 extends. The plurality of liquid processing units 13 are disposed to face the plurality of processing units 15 via the conveyance space 11.

The plurality of liquid processing units 13 include, for example, a total of four liquid processing units 13 of two units in the front-back directions X and two units in the vertical directions Z. The plurality of liquid processing units 13 include a coating unit BARC and a coating unit RESIST. The coating unit BARC forms an antireflection film on the main surface of the substrate W. The coating unit RESIST forms a resist film on the main surface (that is, on the antireflection film) of the substrate W.

Each of the coating units BARC and RESIST includes a holding and rotating unit 17, a nozzle 19, and a nozzle moving unit 21. The holding and rotating unit 17 includes a spin chuck that holds one substrate W in a horizontal orientation and an electric motor that rotates the spin chuck about a vertical axis passing through the center of the substrate W. The spin chuck holds the substrate W through vacuum suction, for example. The nozzle 19 supplies a coating liquid onto the upper surface of the substrate W held by the holding and rotating unit 17. The coating liquid is a liquid for forming an antireflection film or a photoresist liquid. The nozzle moving unit 21 moves the nozzle 19 to any positions. The nozzle moving unit 21 includes, for example, an electric motor.

The plurality of processing units 15 include, for example, a total of 15 processing units 15 of three units in the front-back directions X and five units in the vertical directions Z. The plurality of processing units 15 include a cooling unit CP and a heating/cooling unit PHP. The plurality of processing units 15 may include an edge exposure unit (not illustrated) that performs exposure processing on the peripheral portion of the substrate W.

The cooling unit CP cools the substrate W. The heating/cooling unit PHP continuously performs heating processing (baking processing) and cooling processing. The cooling unit CP and the heating/cooling unit PHP include a plate 23 on which the substrate W is to be placed. The plate 23 is heated by, for example, a heater such as an electric heater. The plate 23 is cooled by, for example, a water-cooled circulation mechanism or a Peltier element.

The conveyance robots TR1 and TR2 are provided inside the coating processing block 3. As illustrated in Fig. 2, the conveyance robot TR1 is provided in the conveyance space 11 of the upper coating processing layer 3A. The conveyance robot TR2 is provided in the conveyance space 11 of the lower coating processing layer 3B. Details of the conveyance robots TR1 and TR2 will be described later.

### <1-3. Configuration of Development Processing Block>

The development processing block 4 individually performs preset development processing (second processing) on a plurality of (for example, 25) substrates W. The development processing block 4 is coupled to the coating processing block 3. In other words, the development processing block 4 is disposed to be adjacent to the back side of the coating processing block 3. The development processing block 4 includes a development processing layer 4A and a development processing layer 4B stacked in the vertical directions Z. The development processing layer 4A is disposed on the upper side of the development processing layer 4B. The development processing layer 4A is disposed on the same layer (height position) as the coating processing layer 3A. In the same manner, the development processing layer 4B is disposed on the same layer (height position) as the coating processing layer 3B.

Each of the two development processing layers 4A and 4B includes a conveyance space 25, a plurality of liquid processing units 27, a plurality of processing units 29, a first stack 31, and a conveyance robot TR3 (TR4). The development processing layer 4B has substantially the same configuration as the development processing layer 4A. Thus, the configuration of the upper development processing layer 4A will be described as a representative.

As illustrated in Fig. 1, the conveyance space 25 extends in the front-back directions X. The plurality of liquid processing units 27 and the plurality of processing units 29 are disposed in the front-back directions X in which the conveyance space 25 extends. The plurality of liquid processing units 27 are disposed to face the plurality of processing units 29 via the conveyance space 25.

The plurality of liquid processing units 27 include, for example, a total of four liquid processing units 27 of two units in the front-back directions X and two units in the vertical directions Z. The plurality of liquid processing units 27 include a development unit DEV. The development unit DEV develops the substrate W exposed by the exposure device EXP.

The development unit DEV includes a holding and rotating unit 17, a nozzle 33, and a nozzle moving unit 35. The nozzle 33 supplies a developing liquid onto the upper surface of the substrate W held by the holding and rotating unit 17. The nozzle moving unit 35 moves the nozzle 33 to any positions. The nozzle moving unit 35 includes, for example, an electric motor.

The plurality of processing units 29 include, for example, a total of 10 processing units 29 of two units in the front-back directions X and five units in the vertical directions Z. The plurality of processing units 29 include a heating unit HP and a cooling unit CP. The heating unit HP heats the substrate W. The heating unit HP includes a plate 23 and a heater such as an electric heater.

The first stack 31 is provided in one section adjacent to the conveyance space 25 and the interface block 5. As illustrated in Fig. 3, the first stack 31 of the upper development processing layer 4A includes one or more heating/cooling units PHP and substrate placement tables PS3 and PS6. In the development processing layer 4A, one or more heating/cooling units PHP and the substrate placement tables PS3 and PS6 are disposed so as to be stacked in the vertical directions Z. The substrate placement tables PS3 and PS6 are disposed one above the other.

The first stack 31 of the lower development processing layer 4B includes one or more heating/cooling units PHP and substrate placement tables PS13 and PS16. In the development processing layer 4B, one or more heating/cooling units PHP and the substrate placement tables PS13 and PS16 are disposed so as to be stacked in the vertical directions Z. One substrate W is placed on each of the substrate placement tables PS3, PS6, PS13, and PS16.

The conveyance robots TR3 and TR4 are provided inside the development processing block 4. As illustrated in Fig. 2, the conveyance robot TR3 is provided in the conveyance space 25 of the upper development processing layer 4A. The conveyance robot TR4 is provided in the conveyance space 25 of the lower development processing layer 4B. Details of the conveyance robots TR3 and TR4 will be described later. The types and the numbers of the liquid processing units 13 and 27 and the processing units 15 and 29 are changed as necessary.

### <1-4. Details of Substrate Placement Table and Conveyance Robot>

The substrate processing apparatus 1 further includes eight substrate placement tables PS1, PS2, PS7, PS8, PS11, PS12, PS17, and PS18. The substrate placement tables PS1 and PS8 are provided at the boundary between the indexer block 2 and the upper coating processing layer 3A. The substrate placement tables PS11 and PS18 are provided at the boundary between the indexer block 2 and the lower coating processing layer 3B.

The substrate placement tables PS2 and PS7 are provided one above the other at the boundary between the upper coating processing layer 3A and the upper development processing layer 4A. The substrate placement tables PS12 and PS17 are provided one above the other at the boundary between the lower coating processing layer 3B and the lower development processing layer 4B. The four substrate placement tables PS2, PS7, PS12, and PS17 are disposed in the vertical directions Z. The substrate placement table PS7 is disposed at a position higher than the substrate placement table PS2. The substrate placement table PS17 is disposed at a position higher than the substrate placement table PS12.

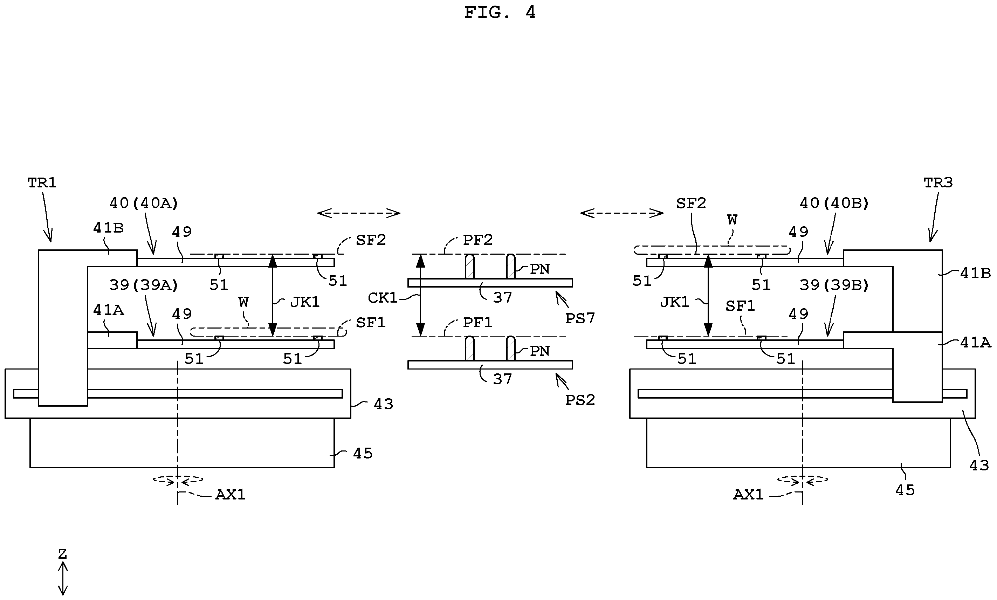

One substrate W is placed on each of the eight substrate placement tables PS1, PS2, PS7, PS8, PS11, PS12, PS17, and PS18. Each of the eight substrate placement tables PS1, PS2, PS7, PS8, PS11, PS12, PS17, and PS18 includes, for example, a table member 37 and three support pins PN (see Fig. 4). The substrate placement tables PS3, PS6, PS13, and PS16 and a substrate placement table PS5 to be described later are configured in the same manner.

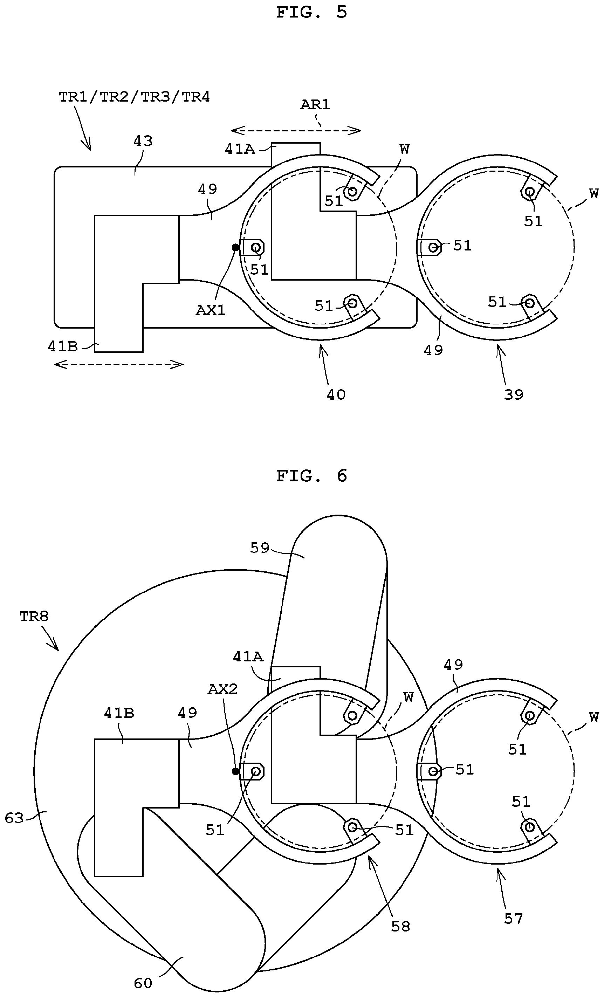

See Figs. 2, 4, and 5. Fig. 4 is a side view illustrating two conveyance robots TR1 and TR3 and two substrate placement tables PS2 and PS7. Fig. 5 is a plan view illustrating two hands 39 and 40 and a reciprocating unit 43 of each of the conveyance robots TR1, TR2, TR3, and TR4 of the coating processing block 3 and the development processing block 4.

Each of the four conveyance robots TR1, TR2, TR3, and TR4 includes two hands 39 and 40 disposed one above the other and individually moves the two hands 39 and 40. This makes it possible to deliver and receive the substrate W to and from, for example, the substrate placement tables PS2 and PS7 disposed one above the other. Each of the four conveyance robots TR1 to TR4 further includes hand supports 41A and 41B, the reciprocating unit 43, a rotating unit 45, a horizontal movement unit 47, and a vertical movement unit 48.

Each of the two hands 39 and 40 is configured to support one substrate W in a horizontal orientation. As illustrated in Fig. 5, each of the hands 39 and 40 includes a C-shaped hand body 49 and a plurality of (for example, 3 or 4) support members 51 provided on the hand body 49. The plurality of support members 51 are disposed on the inner peripheral side of the C-shaped portion of the hand body 49, for example. The plurality of support members 51 support the peripheral portion of the substrate W from the lower surface side of the substrate W. The hand 40 is disposed at a position higher than the hand 39.

As indicated by the arrow AR1 in Fig. 5, the reciprocating unit 43 supports the hand 39 via the hand support 41A such that the hand 39 can linearly move. The reciprocating unit 43 supports the hand 40 via the hand support 41B such that the hand 40 can linearly move. The reciprocating unit 43 individually moves the two hands 39 and 40 forward and backward. The reciprocating unit 43 includes, for example, two electric motors, two screw shafts, and two guide rails.

The rotating unit 45 rotates the reciprocating unit 43 about a vertical axis AX1 passing through the reciprocating unit 43. This can integrally change the orientations of the two hands 39 and 40, the hand supports 41A and 41B, and the reciprocating unit 43.

The horizontal movement unit 47 moves the rotating unit 45 in the front-back directions X. The vertical movement unit 48 moves the horizontal movement unit 47 in the vertical directions Z. That is, the horizontal movement unit 47 and the vertical movement unit 48 move the rotating unit 45 in the front-back directions X and the vertical directions Z (two-dimensional directions). This can integrally move the two hands 39 and 40, the hand supports 41A and 41B, and the reciprocating unit 43 in the front-back directions X and the vertical directions Z. Each of the rotating unit 45, the horizontal movement unit 47, and the vertical movement unit 48 includes, for example, an electric motor.

Here, the relationship between a support interval JK1 and a placement interval CK1 will be described with reference to Fig. 4. The support interval JK1 is an interval in an up-down direction (vertical direction Z) between two support surfaces SF1 and SF2 of the two hands 39 and 40 of each of the two conveyance robots TR1 and TR3. The support surface SF1 is a surface including the tips of, for example, three support members 51 of the hand 39. The support surface SF2 is a surface including the tips of, for example, three support members 51 of the hand 40. Each of the support surfaces SF1 and SF2 is a surface on which the substrate W is to be supported.

On the other hand, the placement interval CK1 is an interval in an up-down direction between two placement surfaces PF1 and PF2 of the two substrate placement tables PS2 and PS7. The placement surface PF1 is a surface including the tips of the three support pins PN of the substrate placement table PS2. The placement surface PF2 is a surface including the tips of the three support pins PN of the substrate placement table PS7. Each of the placement surfaces PF1 and PF2 is a surface on which the substrate W is to be placed.

In the present embodiment, the support interval JK1 between the two hands 39 and 40 of each of the two upper conveyance robots TR1 and TR3 is set to coincide with the placement interval CK1 between the two substrate placement tables PS2 and PS7. The support interval JK1 between the two hands 39 and 40 of each of the two lower conveyance robots TR2 and TR4 is also set to coincide with the placement interval CK1 between the two substrate placement tables PS12 and PS17.

Each of the substrate placement tables PS2 and PS12 corresponds to a first placement table of the present invention. Each of the substrate placement tables PS7 and PS17 corresponds to a second placement table of the present invention. Each of the four conveyance robots TR1 to TR4 corresponds to a first substrate conveyance robot of the present invention.

When the conveyance robot TR1 (TR2) corresponds to the first substrate conveyance robot of the present invention, the conveyance robot TR3 (TR4) corresponds to a second substrate conveyance robot of the present invention. Accordingly, the hands 39 and 40 of the conveyance robot TR1 (TR2) correspond to a first hand and a second hand of the present invention, and the hands 39 and 40 of the conveyance robot TR3 (TR4) correspond to a third hand and a fourth hand of the present invention. The support interval JK1 between the hands 39 and 40 of the conveyance robot TR1 (TR2) corresponds to a support interval of the present invention. The support interval JK1 between the hands 39 and 40 of the conveyance robot TR3 (TR4) corresponds to a second support interval of the present invention.

### <1-5. Configuration of Interface Block (IF Block)>

See Figs. 1 to 3. The interface block 5 loads and unloads the substrate W into and from the exposure device EXP which is an external device. The interface block 5 is coupled to the development processing block 4. In other words, the interface block 5 is disposed to be adjacent to the back side of the development processing block 4. The interface block 5 includes two conveyance robots TR7 and TR8 and a second stack 53.

The two conveyance robots TR7 and TR8 are provided inside the interface block 5. The two conveyance robots TR7 and TR8 are disposed in the width directions Y (see Fig. 1). Specifically, the conveyance robot TR7 is disposed on the back side of the first stack 31. The conveyance robot TR8 is disposed on the left side of the conveyance robot TR7.

The second stack 53 is disposed between the two conveyance robots TR7 and TR8. As illustrated in Fig. 3, the second stack 53 includes one or more substrate placement tables PS-CP, a substrate placement table PS5, and a buffer BF. The one or more substrate placement tables PS-CP, the substrate placement table PS5, and the buffer BF are disposed so as to be stacked in the vertical directions Z. The substrate placement table PS-CP is a placement table having a cooling function. The buffer BF temporarily accommodates the substrate W.

The conveyance robot TR7 can convey the substrate W between the two first stacks 31 (one or more heating/cooling units PHP and the substrate placement tables PS3 and PS6 (PS13 and PS16)) of the two development processing layers 4A and 4B and the second stack 53 (one or more substrate placement tables PS-CP, the substrate placement table PS5, and the buffer BF). The conveyance robot TR7 includes two hands 55 and 56. Each of the two hands 55 and 56 supports one substrate W in a horizontal orientation. The conveyance robot TR7 individually moves the two hands 55 and 56 in the horizontal directions (the front-back directions X and the width directions Y) and the vertical directions Z, and rotates the hand 55 and 56 about a vertical axis.

### <1-6. Details of Conveyance Robot That Accesses Exposure Device>

See Figs. 1, 6, and 7. The conveyance robot TR8 conveys the substrate W between the second stack 53 (one or more substrate placement tables PS-CP and the substrate placement table PS5) and the exposure device EXP. The conveyance robot TR8 is configured like a horizontal articulated robot. The conveyance robot TR8 includes two hands 57 and 58 disposed one above the other, and individually moves the two hands 57 and 58. This makes it possible to deliver and receive the substrate W to and from the substrate placement tables PS31 and PS32 of each placement unit 71 of the exposure device EXP. The conveyance robot TR8 further includes two articulated arms 59 and 60 and a lifting unit 63.

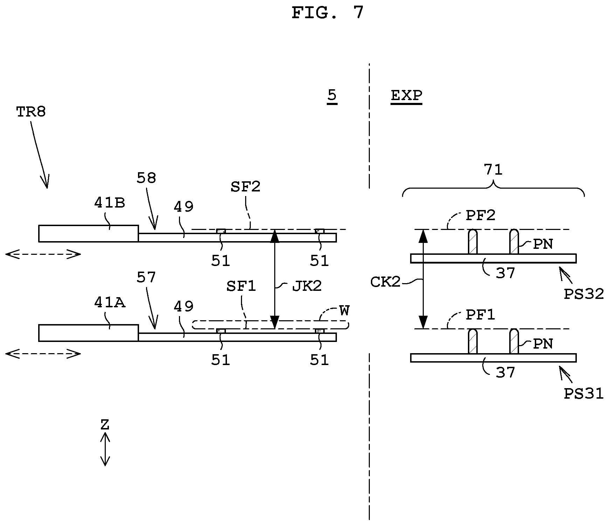

Each of the two hands 57 and 58 supports one substrate W in a horizontal orientation. The hand 58 is disposed at a position higher than the hand 57. Each of the hands 57 and 58 is configured in the same manner as, for example, the two hands 39 and 40 of the conveyance robot TR1. Thus, in Figs. 6 and 7, the overlapping configuration is denoted by the same reference numerals as those of the four conveyance robots TR1 to TR4.

A distal end portion of the articulated arm 59 is connected to the hand 57 via the hand support 41A. A distal end portion of the articulated arm 60 is connected to the hand 58 via the hand support 41B. The hand 57 can rotate about the vertical axis with respect to the distal end portion of the articulated arm 59. The hand 58 can also rotate about the vertical axis with respect to the distal end portion of the articulated arm 60. Further, two base end portions of the two articulated arms 59 and 60 are each connected to the lifting unit 63 so as to be rotatable about a vertical axis. The lifting unit 63 lifts and lowers the two hands 57 and 58 via the two articulated arms 59 and 60.

The lifting unit 63 may be configured to rotate the two hands 57 and 58 about a vertical axis AX2 via the two articulated arms 59 and 60. The lifting unit 63 may be configured to be moved in the width directions Y by a horizontal moving unit (not illustrated). Each of the two articulated arms 59 and 60 and the lifting unit 63 includes an electric motor.

The conveyance robot TR8 loads and unloads the substrate W into and from the exposure device EXP which is an external device. As illustrated in Figs. 1 and 7, the exposure device EXP includes two placement units 71 and a conveyance robot 73. Each of the two placement units 71 includes two substrate placement tables PS31 and PS32 disposed in the vertical directions Z.

That is, the two substrate placement tables PS31 and PS32 are provided inside the exposure device EXP. Each of the two substrate placement tables PS31 and PS32 includes a table member 37 and three support pins PN like the substrate placement table PS2, for example. The substrate placement table PS32 is disposed at a position higher than the substrate placement table PS31. The conveyance robot 73 conveys the substrate W before exposure from the two placement units 71 to an exposure processing region, and conveys the substrate W after exposure from the exposure processing region to the two placement units 71. The exposure processing region includes a stage that holds the substrate W in a horizontal orientation.

The placement interval CK2 is an interval in an up-down direction between two placement surfaces PF1 and PF2 of the two substrate placement tables PS31 and PS32. The support interval JK2 is an interval in an up-down direction between two support surfaces SF1 and SF2 of the two hands 57 and 58. The support interval JK2 between the two hands 57 and 58 is set to coincide with the placement interval CK2 between the two substrate placement tables PS31 and PS32. The placement interval CK2 may be the same as or different from the placement interval CK1 illustrated in Fig. 4. The support interval JK2 may be the same as or different from the support interval JK1 illustrated in Fig. 4.

### <1-7. Controller>

As illustrated in Fig. 1, the substrate processing apparatus 1 includes a controller 81 and a storage unit 83. The controller 81 controls each configuration of the substrate processing apparatus 1. The controller 81 includes one or more processors such as a central processing unit (CPU). The storage unit 83 includes, for example, at least one of a read-only memory (ROM), a random-access memory (RAM), and a hard disk. The storage unit 83 stores a computer program necessary for controlling each configuration of the substrate processing apparatus 1.

### <2. Operation of Substrate Processing Apparatus>

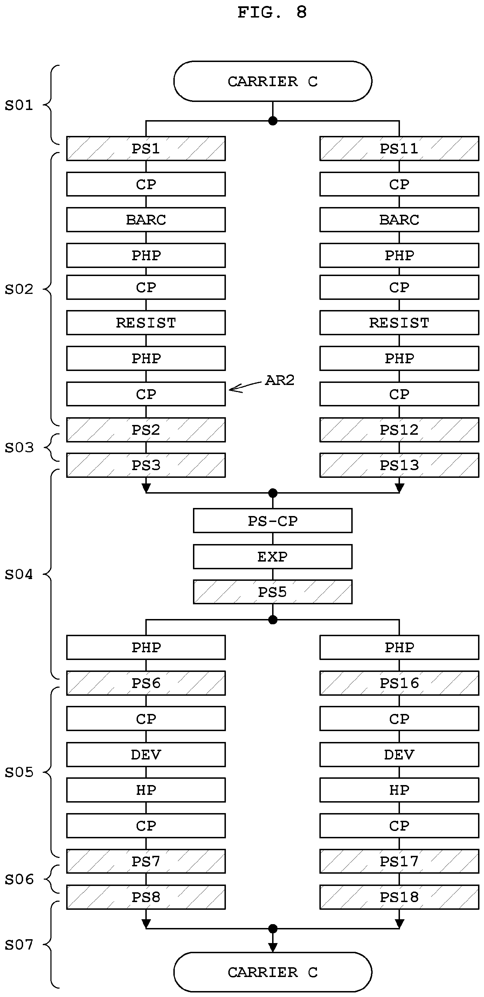

Next, an operation of the substrate processing apparatus 1 will be described. Fig. 8 is a flowchart illustrating an example of a processing step of the substrate processing apparatus 1. The processing in the coating processing layer 3B and the development processing layer 4B is the same as the processing in the coating processing layer 3A and the development processing layer 4A. Thus, processing in the coating processing layer 3A and the development processing layer 4A will be described as a representative.

### [Step S01] Conveyance of Substrate from Carrier

See Fig. 1. An external carrier conveyance robot conveys the carrier C to one of the four carrier placement shelves 7. The indexer robot IR of the indexer block 2 takes out one substrate W from the carrier C placed on the carrier placement shelf 7. The indexer robot IR conveys the one substrate W to, for example, the substrate placement table PS1 among the substrate placement tables PS1 and PS11. The indexer robot IR sequentially conveys, for example, 25 substrates W stored in the carrier C to one of the substrate placement tables PS1 and PS11.

### [Step S02] Operation with Coating Processing Block

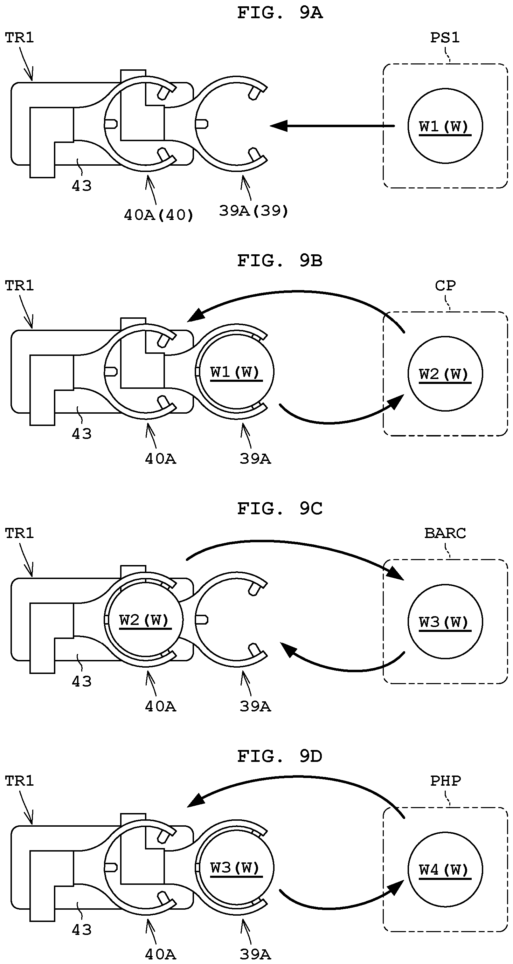

The conveyance robot TR1 includes hands 39A and 40A as the hands 39 and 40. The conveyance robot TR1 conveys substrates W to the side of the development processing layer 4A while performing an operation of replacing two substrates W using the hands 39A and 40A. In Figs. 9A to 9D, four substrates W are distinguished as substrates W1, W2, W3, and W4.

See Fig. 9A. It is assumed that the two hands 39A and 40A do not support any substrate W. The conveyance robot TR1 receives the substrate W1 from the substrate placement table PS1 using, for example, the hand 39A. Thereafter, the conveyance robot TR1 moves the hands 39A and 40A, the reciprocating unit 43, and the like to the vicinity of the cooling unit CP as the next conveyance destination.

See Fig. 9B. The cooling unit CP has finished cooling processing on the substrate W2. The conveyance robot TR1 receives the substrate W2 using the hand 40A, and then places (passes) the substrate W1 supported by the hand 39A on the cooling unit CP. This makes it possible to exchange the substrate W1 of the conveyance robot TR1 and the substrate W2 of the cooling unit CP. That is, the substrate W2 is received from one preset position, and a substrate W is placed at the one position. Thereafter, the conveyance robot TR1 moves the hands 39A and 40A, the reciprocating unit 43, and the like to the vicinity of the coating unit BARC as the next conveyance destination.

See Fig. 9C. The coating unit BARC has formed an antireflection film on the substrate W3. The conveyance robot TR1 receives the substrate W3 using the hand 39A, and then places the substrate W2 supported by the hand 40A on the coating unit BARC. This makes it possible to exchange the substrate W2 of the conveyance robot TR1 and the substrate W3 of the coating unit BARC. Thereafter, the conveyance robot TR1 moves the hands 39A and 40A, the reciprocating unit 43, and the like to the vicinity of the heating/cooling unit PHP as the next conveyance destination.

See Fig. 9D. The heating/cooling unit PHP has finished baking processing and cooling processing on the coated substrate W4. The conveyance robot TR1 receives the substrate W4 using the hand 40A, and then places the substrate W3 supported by the hand 39A on the heating/cooling unit PHP. This makes it possible to exchange the substrate W3 of the conveyance robot TR1 and the substrate W4 of the heating/cooling unit PHP. Thereafter, the conveyance robot TR1 moves the hands 39A and 40A, the reciprocating unit 43, and the like to the vicinity of the cooling unit CP as the next conveyance destination.

Thereafter, the substrate W is conveyed to the cooling unit CP, the coating unit RESIST, the heating/cooling unit PHP, and the cooling unit CP in this order. As described in Figs. 9B to 9D, the conveyance robot TR1 conveys substrates W to the cooling unit CP, the coating unit RESIST, the heating/cooling unit PHP, and the cooling unit CP in this order while performing the replacement operation of two substrates W. The coating unit RESIST forms a resist film on the main surface of the substrate W.

After the conveyance robot TR1 replaces the two substrates W with respect to the cooling unit CP indicated by the arrow AR2 in Fig. 8, the hand 39A supports the substrate W subjected to the cooling processing by the cooling unit CP. Thereafter, the conveyance robot TR1 moves the hands 39A and 40A, the reciprocating unit 43, and the like to the vicinity of the substrate placement table PS2 as the next conveyance destination. Specifically, the conveyance robot TR1 causes the lower hand 39A to face the substrate placement table PS2 and causes the upper hand 40A to face the substrate placement table PS7.

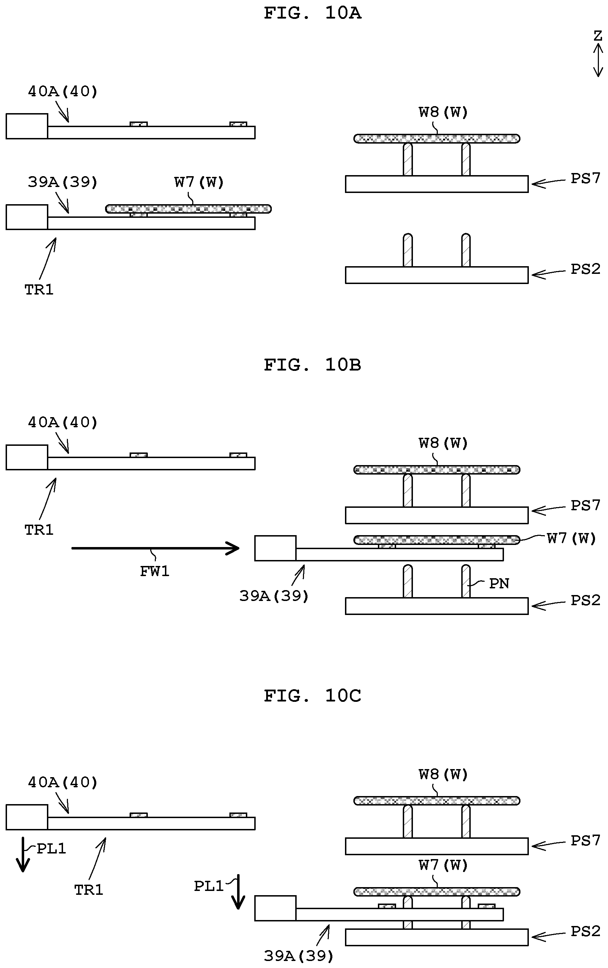

Here, the operation of the conveyance robot TR1 will be described with reference to Figs. 10A to 11C. In Figs. 10A to 11C and Figs. 12A to 13C, substrates W are distinguished as substrates W7, W8, and W9. The substrate placement table PS2 is used for sending the substrates W from the coating processing layer 3A to the development processing layer 4A. The substrate placement table PS7 is used for returning the substrates W from the development processing layer 4A to the coating processing layer 3A.

See Fig. 10A. The hand 39A of the conveyance robot TR1 supports the substrate W7 on which the resist film is formed by performing coating processing. It is assumed that the substrate W8 subjected to development processing by the development processing layer 4A is placed on the substrate placement table PS7.

See Fig. 10B. First, the reciprocating unit 43 of the conveyance robot TR1 causes the hand 39A supporting the substrate W7 to move forward toward the substrate placement table PS2 (first hand forward operation FW1). This causes the substrate W7 supported by the hand 39A to move to a position above the three support pins PN of the substrate placement table PS2 without contacting the three support pins PN of the substrate placement table PS2. That is, the hand 39A is moved to the upper surface side of the substrate placement table PS2.

See Fig. 10C. Thereafter, the conveyance robot TR1 delivers the substrate W7 to the substrate placement table PS2 with the hand 39A (placement operation PL1). Specifically, the vertical movement unit 48 of the conveyance robot TR1 integrally and slightly lowers the hands 39A and 40A, the reciprocating unit 43, and the like. This can place the substrate W7 supported by the hand 39A onto the tips of the three support pins PN. The hand 40A is lowered together with the hand 39A.

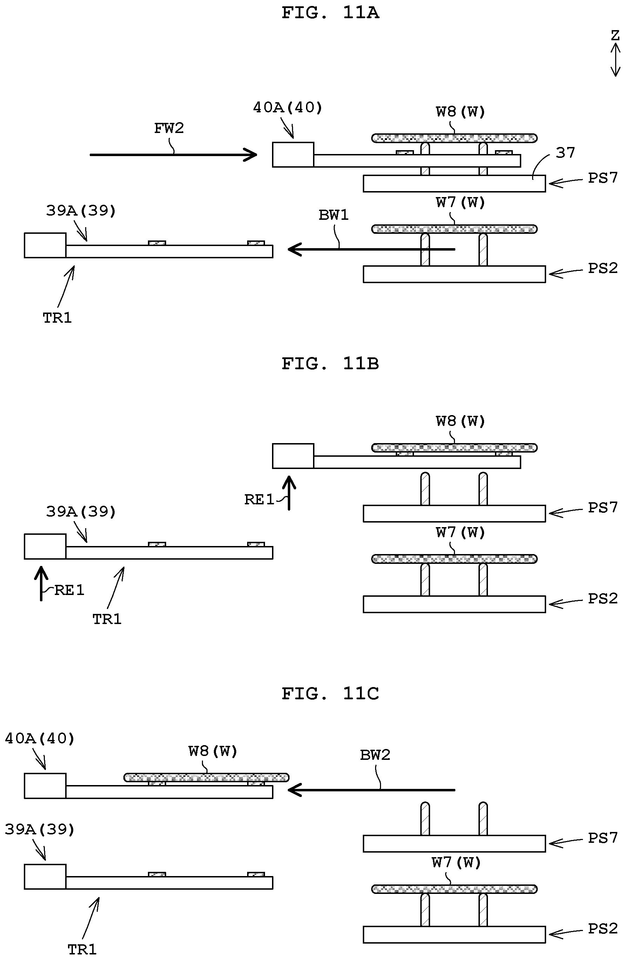

See Fig. 11A. Thereafter, the reciprocating unit 43 of the conveyance robot TR1 moves backward the hand 39A from (the upper surface side of) the substrate placement table PS2 (first hand backward operation BW1). While performing this first hand backward operation BW1, the reciprocating unit 43 of the conveyance robot TR1 causes the hand 40A supporting no substrate W to move forward toward the substrate placement table PS7 (second hand forward operation FW2). That is, the conveyance robot TR1 performs the first hand backward operation BW1 and the second hand forward operation FW2 in parallel.

The support interval JK1 between the hands 39A and 40A of the conveyance robot TR1 coincides with the placement interval CK1 between the substrate placement tables PS2 and PS7 (see Fig. 4). Thus, it is possible to move the hand 40A to the upper surface side of the substrate placement table PS7 without bringing the hand 40A into contact with the substrate placement table PS7 and the substrate W8 on the substrate placement table PS7. In addition, by performing the first hand backward operation BW1 and the second hand forward operation FW2 in parallel, as illustrated in Figs. 10B to 11C, it is possible to efficiently perform a series of operations of placing the substrate W7 on the substrate placement table PS2 and receiving the substrate W8 from the substrate placement table PS7.

In Fig. 11A, the hand 40A enters between the lower surface of the substrate W8 and the upper surface of the table member 37 of the substrate placement table PS7.

See Fig. 11B. Thereafter, the conveyance robot TR1 receives the substrate W8 from the substrate placement table PS7 with the hand 40A (reception operation RE1). Specifically, the vertical movement unit 48 of the conveyance robot TR1 integrally and slightly lifts the hands 39A and 40A, the reciprocating unit 43, and the like. This can support the substrate W8 with the hand 40A.

See Fig. 11C. Thereafter, the reciprocating unit 43 of the conveyance robot TR1 moves backward the hand 40A supporting the substrate W8 from the substrate placement table PS7 (second hand backward operation BW2). Thereafter, the conveyance robot TR1 conveys the substrate W8 received by the hand 40A to the substrate placement table PS8 (see step S06 described later). Thereafter, the conveyance robot TR1 again receives the substrate W from the substrate placement table PS1 (see Fig. 9A).

### [Step S03] Operation with Development Processing Block

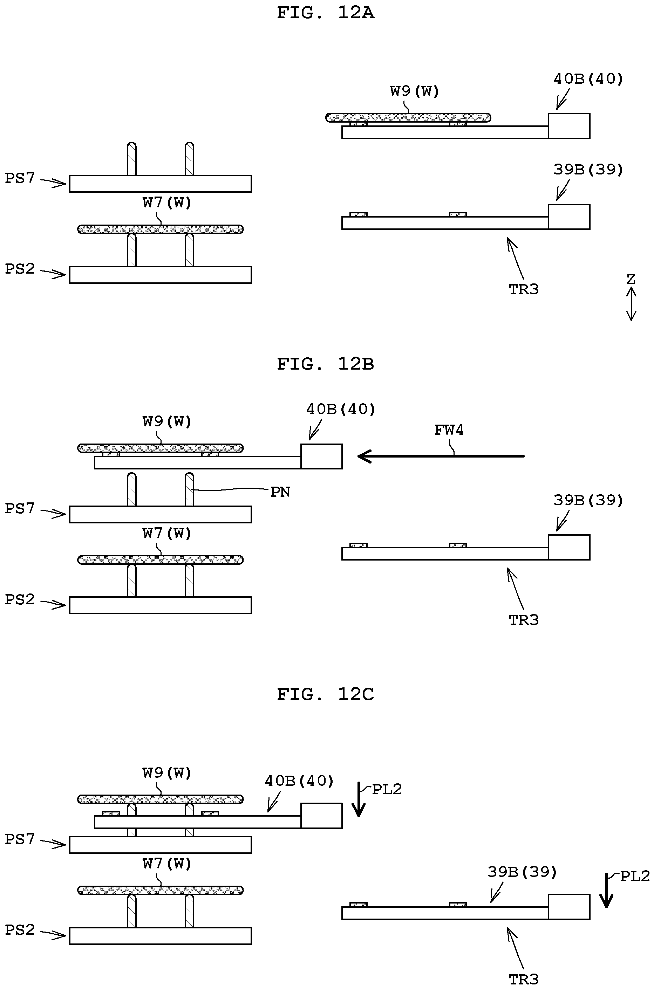

It is assumed that the conveyance robot TR3 of the development processing layer 4A includes hands 39B and 40B as the hands 39 and 40. Here, the operation of the conveyance robot TR3 will be described with reference to Figs. 12A to 13C.

See Fig. 12A. The conveyance robot TR3 moves the hands 39B and 40B, the reciprocating unit 43, and the like to the vicinity of the substrate placement table PS2. The conveyance robot TR3 causes the lower hand 39B to face the substrate placement table PS2 and causes the upper hand 40B to face the substrate placement table PS7. It is assumed that the substrate W7 conveyed by the conveyance robot TR1 is placed on the substrate placement table PS2. It is assumed that the hand 40B of the conveyance robot TR3 supports the substrate W9 that has been developed.

See Fig. 12B. First, the reciprocating unit 43 of the conveyance robot TR3 causes the hand 40B supporting the substrate W9 to move forward toward the substrate placement table PS7 (fourth hand forward operation FW4). This causes the substrate W9 supported by the hand 40B to move to a position above the three support pins PN of the substrate placement table PS7 without contacting the three support pins PN of the substrate placement table PS7.

See Fig. 12C. Thereafter, the conveyance robot TR3 delivers the substrate W9 to the substrate placement table PS7 with the hand 40B (placement operation PL2). Specifically, the vertical movement unit 48 of the conveyance robot TR3 integrally and slightly lowers the hands 39B and 40B, the reciprocating unit 43, and the like. This can place the substrate W9 supported by the hand 40B onto the tips of the three support pins PN of the substrate placement table PS7.

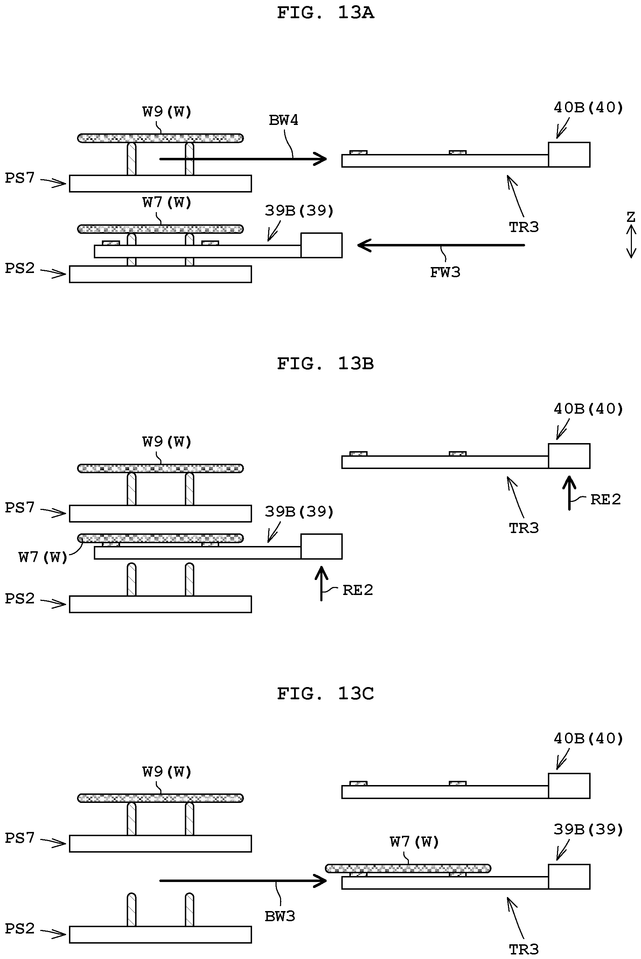

See Fig. 13A. Thereafter, the reciprocating unit 43 of the conveyance robot TR3 moves backward the hand 40B from the substrate placement table PS7 (fourth hand backward operation BW4). While performing this fourth hand backward operation BW4, the reciprocating unit 43 of the conveyance robot TR3 causes the hand 39B supporting no substrate W to move forward toward the substrate placement table PS2 (third hand forward operation FW3). That is, the conveyance robot TR3 performs the fourth hand backward operation BW4 and the third hand forward operation FW3 in parallel.

The support interval JK1 between the hands 39B and 40B of the conveyance robot TR3 coincides with the placement interval CK1 between the substrate placement tables PS2 and PS7 (see Fig. 4). Thus, it is possible to move the hand 39B to the upper surface side of the substrate placement table PS2 without bringing the hand 39B into contact with the substrate placement table PS2 and the substrate W7 on the substrate placement table PS2. In addition, by performing the fourth hand backward operation BW4 and the third hand forward operation FW3 in parallel, it is possible to efficiently perform a series of operations in Figs. 12B to 13C.

See Fig. 13B. Thereafter, the conveyance robot TR3 receives the substrate W7 from the substrate placement table PS2 with the hand 39B (reception operation RE2). Specifically, the vertical movement unit 48 of the conveyance robot TR3 integrally and slightly lifts the hands 39B and 40B, the reciprocating unit 43, and the like. This can support the substrate W7 with the hand 39B.

See Fig. 13C. Thereafter, the reciprocating unit 43 of the conveyance robot TR3 moves backward the hand 39B supporting the substrate W7 from the substrate placement table PS2 (third hand backward operation BW3). Thereafter, the conveyance robot TR3 moves the hands 39B and 40B, the reciprocating unit 43, and the like to the vicinity of the substrate placement table PS3 (see Fig. 3). Thereafter, the conveyance robot TR3 places the substrate W7 onto the substrate placement table PS3 with the hand 39B, and receives the substrate W subjected to exposure processing from the substrate placement table PS6 with the hand 40B.

### [Step S04] Operation with Interface Block

See Figs. 1 to 3. The conveyance robot TR7 of the interface block 5 receives a substrate W (W7) from the substrate placement table PS3 with one of the two hands 55 and 56 and conveys the substrate W to the substrate placement table PS-CP. Thereafter, the conveyance robot TR8 receives the substrate W from the substrate placement table PS-CP, unloads the substrate W to the exposure device EXP, and loads the substrate W subjected to exposure processing.

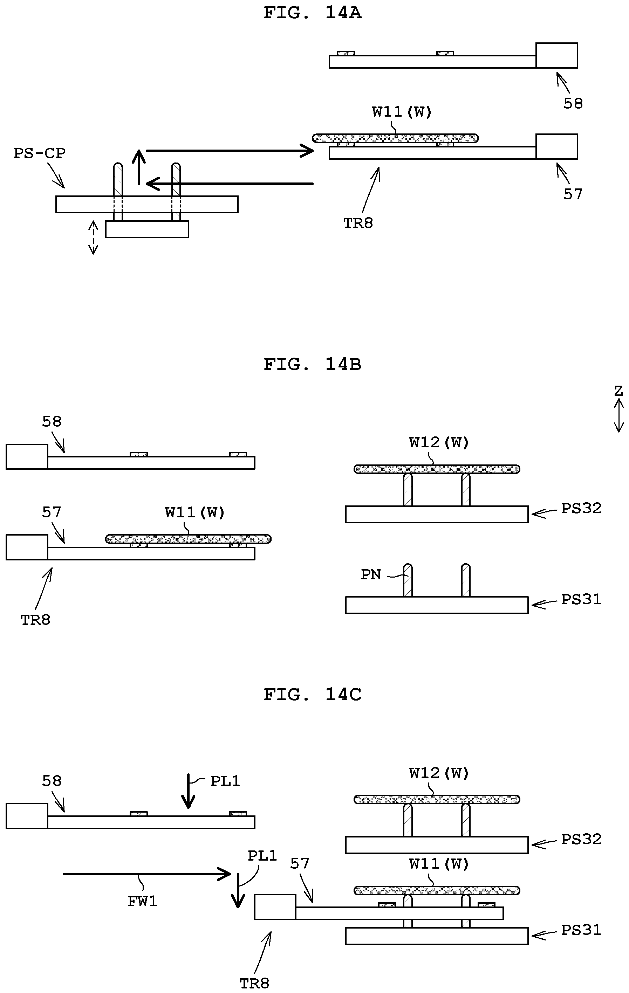

Detailed operation of the conveyance robot TR8 will be described with reference to Figs. 14A to 15C. In Figs. 14A to 15C, substrates W are distinguished as substrates W11 and W12.

See Fig. 14A. First, the lifting unit 63 of the conveyance robot TR8 moves the hands 57 and 58 and the like in the vertical directions Z to move the hand 57 to the vicinity of the substrate placement table PS-CP. Thereafter, the conveyance robot TR8 moves the hand 57 forward and upward to receive the substrate W11 from the substrate placement table PS-CP with the hand 57. Thereafter, the conveyance robot TR8 moves backward the hand 57 supporting the substrate W11.

See Fig. 14B. Thereafter, the conveyance robot TR8 moves the hands 57 and 58 and the like in the vertical directions Z to move the hand 57 to the vicinity of the substrate placement table PS31 of one of the two placement units 71 in the exposure device EXP. That is, the conveyance robot TR8 causes the lower hand 57 to face the substrate placement table PS31 and causes the upper hand 58 to face the substrate placement table PS32.

The substrate placement table PS31 is used for sending the substrates W from the interface block 5 to the exposure device EXP. The substrate placement table PS32 is used for returning the substrates W from the exposure device EXP to the interface block 5. In Fig. 14B, it is assumed that the substrate W12 subjected to exposure processing by the exposure device EXP is placed on the substrate placement table PS32. It is assumed that the hand 57 supports the substrate W11, and the hand 58 supports no substrate W.

See Fig. 14C. Thereafter, the articulated arm 59 of the conveyance robot TR8 causes the hand 57 supporting the substrate W11 to move forward toward the substrate placement table PS31 (first hand forward operation FW1). This causes the substrate W11 supported by the hand 57 to move to a position above the three support pins PN of the substrate placement table PS31. Thereafter, the lifting unit 63 of the conveyance robot TR8 integrally and slightly lowers the hands 57 and 58, and the like to place the substrate W11 onto the substrate placement table PS31 with the hand 57 (placement operation PL1).

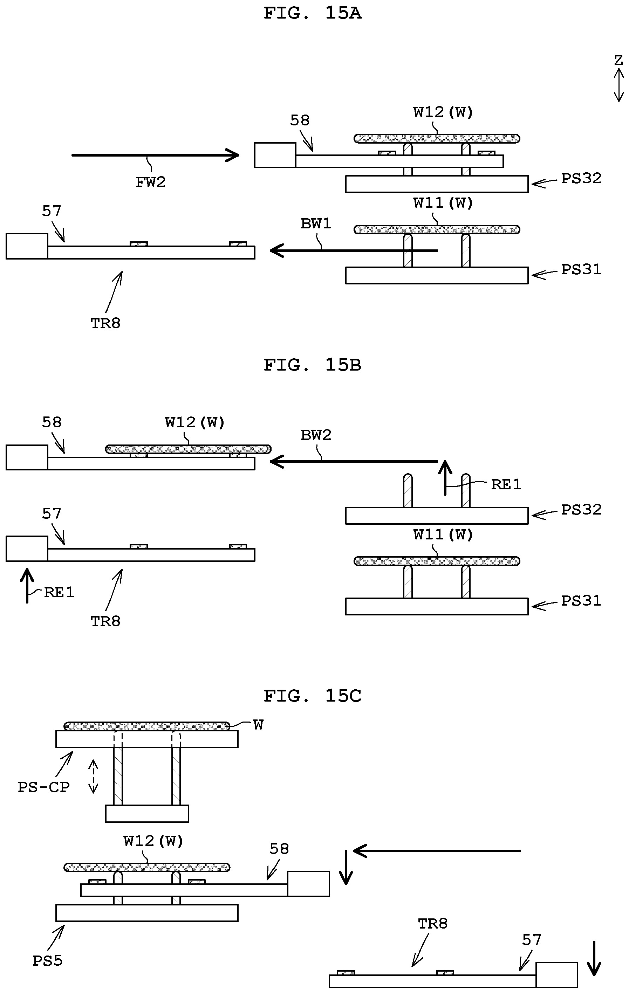

See Fig. 15A. Thereafter, the articulated arm 59 of the conveyance robot TR8 moves backward the hand 57 from the substrate placement table PS31 (first hand backward operation BW1). While performing this first hand backward operation BW1, the articulated arm 60 of the conveyance robot TR8 causes the hand 58 supporting no substrate W to move forward toward the substrate placement table PS32 (second hand forward operation FW2). That is, the conveyance robot TR8 performs the first hand backward operation BW1 and the second hand forward operation FW2 in parallel.

The support interval JK2 between the hands 57 and 58 of the conveyance robot TR8 coincides with the placement interval CK2 between the substrate placement tables PS31 and PS32 (see Fig. 7). Thus, the hand 57 can be moved backward, and at the same time, the hand 58 can be moved forward so that the hand 58 does not come into contact with the substrate placement table PS32 or the like. That is, by performing the first hand backward operation BW1 and the second hand forward operation FW2 in parallel, as illustrated in Figs. 14C to 15B, it is possible to efficiently perform a series of operations of placing the substrate W11 onto the substrate placement table PS31 of the exposure device EXP and receiving the substrate W12 from the substrate placement table PS32.

See Fig. 15B. Thereafter, the lifting unit 63 of the conveyance robot TR8 integrally and slightly lifts the hands 57 and 58, and the like to receive the substrate W12 from the substrate placement table PS32 with the hand 58 (reception operation RE1). Thereafter, the articulated arm 60 of the conveyance robot TR8 moves backward the hand 58 supporting the substrate W12 from the substrate placement table PS32 (second hand backward operation BW2).

See Fig. 15C. Thereafter, the lifting unit 63 of the conveyance robot TR8 moves the hands 57 and 58 in the vertical directions Z to move the hand 58 to the vicinity of the substrate placement table PS5. Thereafter, the articulated arm 60 of the conveyance robot TR8 moves the hand 58 forward and downward to place the substrate W12 onto the substrate placement table PS5 with the hand 58. Thereafter, the conveyance robot TR8 moves backward the hand 58 supporting no substrate W.

Thereafter, as illustrated in Fig. 14A, the conveyance robot TR8 again receives a substrate W from the substrate placement table PS-CP with the hand 57. The conveyance robot 73 of the exposure device EXP receives the substrate W11 from the substrate placement table PS31 and conveys the substrate W11 to the exposure processing region to perform exposure processing. Thereafter, the conveyance robot 73 conveys the substrate W11 subjected to exposure processing from the exposure processing region to the substrate placement table PS32.

See Figs. 1 to 3. The conveyance robot TR7 of the interface block 5 receives a substrate W from the substrate placement table PS5 with one of the two hands 55 and 56 and conveys the substrate W to the heating/cooling unit PHP of the first stack 31 (see Fig. 3). The heating/cooling unit PHP performs baking processing after exposure on the substrate W. Thereafter, the conveyance robot TR7 conveys the substrate W from the heating/cooling unit PHP to the substrate placement table PS6 of the first stack 31.

### [Step S05] Operation with Development Processing Block

The conveyance robot TR3 receives the substrate W from the substrate placement table PS6 with one of the hands 39B and 40B. Thereafter, as described in Figs. 9B to 9D, the conveyance robot TR3 conveys the substrate W to the cooling unit CP, the development unit DEV, the heating unit HP, and the cooling unit CP in this order while performing the replacement operation of two substrates W. The development unit DEV performs development processing on the substrate W. The heating unit HP performs baking processing on the substrate W after development processing.

The conveyance robot TR3 receives the substrate W after the development processing from the cooling unit CP with the upper hand 40B. Thereafter, as illustrated in Figs. 12A to 13C, the conveyance robot TR3 performs a series of operations of placing a substrate W (W9) onto the substrate placement table PS7 and receiving a substrate W (W7) from the substrate placement table PS2.

### [Step S06] Operation with Coating Processing Block

Thereafter, as illustrated in Figs. 10A to 11C, the conveyance robot TR1 of the coating processing layer 3A performs a series of operations of placing the substrate W (W7) onto the substrate placement table PS2 and receiving a substrate W (W8) from the substrate placement table PS7. Thereafter, the horizontal movement unit 47 and the vertical movement unit 48 of the conveyance robot TR1 moves the hands 39A and 40A, the reciprocating unit 43, and the like to the vicinity of the substrate placement table PS8. Thereafter, the conveyance robot TR1 conveys the substrate W (W8) to the substrate placement table PS8.

### [Step S07] Conveyance of Substrate to Carrier

The indexer robot IR of the indexer block 2 receives a substrate W from one of the substrate placement tables PS8 and PS18 and returns the substrate W to the carrier C placed on the carrier placement shelf 7. When the 25 substrates W subjected to the coating processing, the exposure processing, and the development processing are returned to the carrier C, the external carrier conveyance robot conveys the carrier C from the carrier placement shelf 7 to the next destination.

According to the present embodiment, the substrate placement tables PS2 and PS7 are disposed at two different height positions one above the other. The support interval JK1 in an up-down direction between the two support surfaces SF1 and SF2 of the hands 39 and 40 (or the hands 57 and 58) is set to coincide with the placement interval CK1 in an up-down direction between the two placement surfaces PF1 and PF2 of the substrate placement tables PS2 and PS7. In addition, for example, the first hand backward operation BW1 of moving backward the hand 39 after delivering the substrate W to the substrate placement table PS2 and the second hand forward operation FW2 of moving forward the hand 40 to receive the substrate W from the substrate placement table PS7 are performed in parallel.

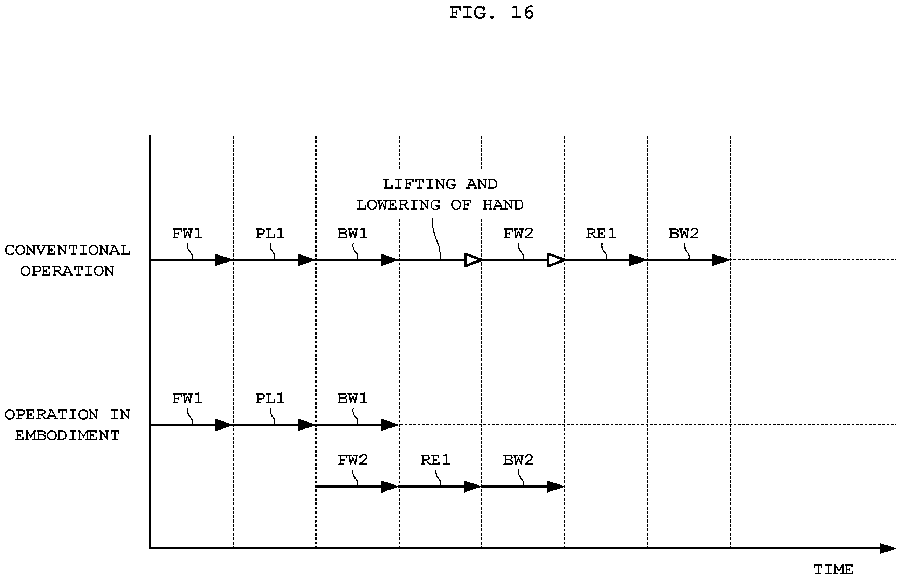

Effects of the present embodiment will be described with reference to Fig. 16. In the conventional operation, the first hand forward operation FW1, the placement operation PL1, the first hand backward operation BW1, the lifting and lowering operations of the hands 39 and 40 (or the hands 57 and 58), the second hand forward operation FW2, the reception operation RE1, and the second hand backward operation BW2 are performed in order. That is, the first hand backward operation BW1 and the second hand forward operation FW2 are not performed in parallel, but the lifting and lowering operations of the hands 39 and 40 are performed therebetween.

On the other hand, in the present embodiment, for example, the support interval JK1 of the hands 39 and 40 coincides with the placement interval CK1 of the substrate placement tables PS2 and PS7. In addition, the first hand backward operation BW1 and the second hand forward operation FW2 are performed in parallel. Thus, the total time from the start of the first hand backward operation BW1 to the end of the second hand forward operation FW2 can be shortened. Thus, the efficiency of conveying the substrate W can be improved in a series of operations of delivering the substrate W to the substrate placement table PS2 then receiving the substrate W from the substrate placement table PS7.

In addition, the substrate placement tables PS2 and PS7 are provided at the boundary between the coating processing block 3 and the development processing block 4. Further, the conveyance robot TR1 of the coating processing block 3 and the conveyance robot TR3 of the development processing block 4 access the substrate placement tables PS2 and PS7. Thus, the efficiency of conveying the substrates W performed by both the conveyance robots TR1 and TR3 placed via the substrate placement tables PS2 and PS7 can improve.

In addition, in recent years, the processing efficiency of the exposure device EXP has been improved. Thus, there is a possibility that the exposure device EXP waits for the conveyance of the substrate W performed by the interface block 5. Thus, for example, it is conceivable to increase the number of the conveyance robots TR8 for conveying the substrate W to the exposure device EXP and conveying the substrate W from the exposure device EXP. However, this is not preferable from the viewpoint of cost and space. According to the present embodiment, the support interval JK2 between the hands 57 and 58 of the conveyance robot TR8 of the interface block 5 is set to coincide with the placement interval CK2 between the substrate placement tables PS31 and PS32 of the external exposure device EXP. Thus, the efficiency of conveying the substrate W performed by the conveyance robot TR8 of the interface block 5 can improve. As a result, the occurrence of a situation in which the exposure device EXP waits for the conveyance of the substrate W performed by the interface block 5 can be prevented.

The present invention is not limited to the embodiment described above, and can be modified as follows.
(1) In the above embodiment, each of the conveyance robots TR1 and TR8 performs the first hand backward operation BW1 and the second hand forward operation FW2 in parallel. That is, the operation of delivering a substrate W is performed before the operation of receiving a substrate W. In this regard, the operation of receiving a substrate W may be performed prior to the operation of delivering a substrate W. In this case, each of the conveyance robots TR1 and TR8 performs the first hand forward operation FW1 and the second hand backward operation BW2 in parallel.
(2) In the above embodiment and Modification (1), the conveyance robot TR3 performs the fourth hand backward operation BW4 and the third hand forward operation FW3 in parallel. That is, the operation of delivering a substrate W is performed before the operation of receiving a substrate W. In this regard, the operation of receiving a substrate W may be performed prior to the operation of delivering a substrate W. In this case, the conveyance robot TR3 performs the third hand backward operation BW3 and the fourth hand forward operation FW4 in parallel.
(3) In the above embodiment and each modification, the substrate placement table PS2 is provided below the substrate placement table PS7. In this regard, the substrate placement table PS2 may be provided above the substrate placement table PS7. In this case, for example, the conveyance robot TR1 delivers a substrate W to the substrate placement table PS2 with the upper hand 40A and receives a substrate W from the substrate placement table PS7 with the lower hand 39A. In the same manner, the substrate placement table PS31 may be provided above the substrate placement table PS32.
(4) In the above embodiment and each modification, the support interval JK1 between the hands 39A and 40A of the conveyance robot TR1 is set to coincide with the placement interval CK1 between the substrate placement tables PS2 and PS7. In this regard, as necessary, the support interval JK1 between the hands 39A and 40A does not have to coincide with the placement interval CK1. In this case, for example, the conveyance robot TR1 does not perform the first hand backward operation BW1 and the second hand forward operation FW2 in parallel.
(5) In the above embodiment and each modification, the support interval JK1 between the hands 39B and 40B of the conveyance robot TR3 is set to coincide with the placement interval CK1 between the substrate placement tables PS2 and PS7. In this regard, as necessary, the support interval JK1 between the hands 39B and 40B does not have to coincide with the placement interval CK1. In this case, for example, the conveyance robot TR3 does not perform the fourth hand backward operation BW4 and the third hand forward operation FW3 in parallel.
(6) In the above embodiment and each modification, the support interval JK2 between the hands 57 and 58 of the conveyance robot TR8 is set to coincide with the placement interval CK2 between the substrate placement tables PS31 and PS32. In this regard, as necessary, the support interval JK2 between the hands 57 and 58 does not have to coincide with the placement interval CK2. In this case, for example, the conveyance robot TR8 does not perform the first hand backward operation BW1 and the second hand forward operation FW2 in parallel.
(7) In the above embodiment and each modification, the support interval JK1 between the hands 39B and 40B of the conveyance robot TR3 may be set to coincide with the placement interval between the substrate placement tables PS3 and PS6 of the first stack 31. In this case, for example, the conveyance robot TR3 may perform the operation of moving backward the hand 39B after delivering the substrate W to the substrate placement table PS3 and the operation of moving forward the hand 40B in parallel.
(8) In the above embodiment and each modification, for example, each of the substrate placement tables PS2, PS3, PS6, PS7, PS31, and PS32 includes the table member 37 and the three support pins PN, but the configuration of the substrate placement tables is not limited to this configuration.
(9) In the above embodiment and each modification, the interface block 5 includes one conveyance robot TR7 to convey the substrate W between the first stack 31 and the second stack 53 (for example, the substrate placement tables PS-CP and PS5). In this regard, a plurality of (for example, two) conveyance robots TR7 may be provided.
(10) In the above embodiment and each modification, the interface block 5 may include at least one of the heating/cooling unit PHP, a pre-exposure cleaning unit (back surface cleaning unit), and a post-exposure cleaning unit. In this case, each of the pre-exposure cleaning unit and the post-exposure cleaning unit may include, for example, a holding and rotating unit that holds the substrate W, and a nozzle that discharges a cleaning liquid onto the substrate W. The holding and rotating unit includes a spin chuck and an electric motor. The pre-exposure cleaning unit cleans the back surface of the substrate W using a brush. The back surface of the substrate W is, for example, the surface opposite to the surface on which a device is formed.
(11) In the above embodiment and each modification, the coating processing block 3 and the development processing block 4 are provided between the indexer block 2 and the interface block 5. In this regard, only one of the coating processing block 3 and the development processing block 4 may be provided between the indexer block 2 and the interface block 5. Three or more processing blocks may be provided between the indexer block 2 and the interface block 5.
(12) In the above embodiment and each modification, for example, in the placement operation PL1 and the reception operation RE1, the conveyance robot TR1 integrally lifts and lowers the hands 39A, 40A, and the like. Alternatively, in the placement operation PL1 and the reception operation RE1, the substrate placement tables PS2 and PS7 may be lifted and lowered by, for example, an electric motor. The same applies to the substrate placement tables PS31 and PS32.
(13) In the above embodiment and each modification, each of the conveyance robots TR1 to TR4 moves the hands 39 and 40 with the reciprocating unit 43. In this regard, like the conveyance robot TR8, the conveyance robots TR1 to TR4 may move the hands 39 and 40 with two articulated arms instead of the reciprocating unit 43. In addition, like the conveyance robot TR1, the conveyance robot TR8 may move the hands 57 and 58 with a reciprocating unit instead of the two articulated arms 59 and 60.

## Claims

1. A substrate processing apparatus (1) that processes a substrate (W), the substrate processing apparatus (1) comprising:
a first substrate conveyance robot (TR1, TR3, TR8) including a first hand (39, 57) and a second hand (40, 58) disposed one above the other, the first substrate conveyance robot (TR1, TR3, TR8) being capable of delivering and receiving the substrate (W) to and from a first placement table (PS2, PS3, PS31) and a second placement table (PS7, PS6, PS32) disposed one above the other by moving the first hand and the second hand; and
a controller (81),
wherein the first hand (39, 57) is configured to support one first substrate (W) in a horizontal orientation,
the second hand (40, 58) is configured to support one second substrate (W) in the horizontal orientation,
a support interval (JK1, JK2) in an up-down direction between a substrate support surface (SF1) of the first hand (39, 57) and a substrate support surface (SF2) of the second hand (40, 58) is set to coincide with a placement interval (CK1, CK2) in an up-down direction between a placement surface (PF1) of the first placement table (PS2, PS3, PS31) on which the substrate (W) is to be placed and a placement surface (PF2) of the second placement table (PS7, PS6, PS32) on which the substrate (W) is to be placed,
the controller (81):
causes the first hand (39, 57) supporting the first substrate (W) to perform a first hand forward operation (FW1) of moving forward toward the first placement table (PS2, PS3, PS31);
delivers the first substrate (W) to the first placement table (PS2, PS3, PS31) with the first hand (39, 57) by causing the first hand (39, 57) and the first placement table (PS2, PS3, PS31) to move up and down with respect to each other;
thereafter, causes the first hand (39, 57) to perform a first hand backward operation (BW1) of moving backward from the first placement table (PS2, PS3, PS31);
causes the second hand (40, 58) to perform a second hand forward operation (FW2) of moving forward toward the second placement table (PS7, PS6, PS32);
receives the second substrate (W) from the second placement table (PS7, PS6, PS32) with the second hand (40, 58) by causing the second hand (40, 58) and the second placement table (PS7, PS6, PS32) to move up and down with respect to each other; and
thereafter, causes the second hand (40, 58) to perform a second hand backward operation (BW2) of moving backward from the second placement table (PS7, PS6, PS32), and
the controller (81) causes the first hand (39, 57) and the second hand (40, 58) to perform either:
the first hand backward operation (BW1) and the second hand forward operation (FW2) in parallel; or
the first hand forward operation (FW1) and the second hand backward operation (BW2) in parallel.

2. The substrate processing apparatus (1) according to claim 1, further comprising:
a processing block (3, 4) that individually performs preset processing on a plurality of substrates (W); and
an interface block (5) that performs loading and unloading of the substrates (W) into and from an external device (EXP), the interface block (5) being coupled to the processing block (3, 4),
wherein the first substrate conveyance robot (TR8) is provided in the interface block (5), and
the first substrate conveyance robot (TR8) delivers and receives the substrates (W) to and from the first placement table (PS31) and the second placement table (P32) provided in the external device (EXP).

3. The substrate processing apparatus (1) according to claim 2, wherein the external device (EXP) is an exposure device (EXP).

4. The substrate processing apparatus (1) according to any one of claims 1 to 3, wherein the controller (81) causes the first hand (39, 57) and the second hand (40, 58) to perform the first hand backward operation (BW1) and the second hand forward operation (FW2) in parallel.

5. The substrate processing apparatus (1) according to claim 1, further comprising:
a first processing block (3) that individually performs preset first processing on a plurality of substrates (W);
a second processing block (4) that individually performs preset second processing on the plurality of substrates (W);
the first placement table (PS2) and the second placement table (PS7) provided one above the other at a boundary between the first processing block (3) and the second processing block (4); and
a second substrate conveyance robot (TR3) including a third hand (39) and a fourth hand (40) disposed one above the other, the second substrate conveyance robot (TR3) delivering and receiving the substrate (W) to and from the first placement table (PS2) and the second placement table (PS7) by moving the third hand (39) and the fourth hand (40),
wherein the first substrate conveyance robot (TR1) is provided in the first processing block (3),
the second substrate conveyance robot (TR3) is provided in the second processing block (4),
the third hand (39) is configured to support the first substrate (W) in a horizontal orientation,
the fourth hand (40) is configured to support one third substrate (W) in the horizontal orientation, and
a second support interval (JK1) in an up-down direction between a substrate support surface (SF1) of the third hand (39) and a substrate support surface (SF2) of the fourth hand (40) is set to coincide with the placement interval (CK1) in an up-down direction between the placement surface (PF1) of the first placement table (PS2) on which the substrate (W) is to be placed and the placement surface (PF2) of the second placement table (PS7) on which the substrate (W) is to be placed,
the controller (81):
causes the third hand (39) to perform a third hand forward operation (FW3) of moving forward toward the first placement table (PS2);
receives the first substrate (W) from the first placement table (PS2) with the third hand (39) by causing the third hand (39) and the first placement table (PS2) to move up and down with respect to each other; and
thereafter, causes the third hand (39) to perform a third hand backward operation (BW3) of moving backward from the first placement table (PS2);
causes the fourth hand (40) supporting the third substrate (W) to perform a fourth hand forward operation (FW4) of moving forward toward the second placement table (PS7);
delivers the third substrate (W) to the second placement table (PS7) with the fourth hand (40) by causing the fourth hand (40) and the second placement table (PS7) to move up and down with respect to each other; and
thereafter, causes the fourth hand (40) to perform a fourth hand backward operation (BW4) of moving backward from the second placement table (PS7), and
the controller causes the third hand (39) and the fourth hand (40) to perform either:
the third hand backward operation (BW3) and the fourth hand forward operation (FW4) in parallel; or
the fourth hand backward operation (BW4) and the third hand forward operation (FW3) in parallel.

6. A method for controlling a substrate processing apparatus (1) that processes a substrate (W),
the substrate processing apparatus (1) including
a first substrate conveyance robot (TR1, TR3, TR8) including a first hand (39, 57) and a second hand (40, 58) disposed one above the other, the first substrate conveyance robot (TR1, TR3, TR8) being capable of delivering and receiving the substrate (W) to and from a first placement table (PS2, PS3, PS31) and a second placement table (PS7, PS6, PS32) disposed one above the other by moving the first hand (39, 57) and the second hand (40, 58),
wherein the first hand (39, 57) is configured to support one first substrate (W) in a horizontal orientation,
the second hand (40, 58) is configured to support one second substrate (W) in the horizontal orientation,
a support interval (JK1, JK2) in an up-down direction between a substrate support surface (SF1) of the first hand (39, 57) and a substrate support surface (SF2) of the second hand (40, 58) is set to coincide with a placement interval (CK1, CK2) in an up-down direction between a placement surface (PF1) of the first placement table (PS2, PS3, PS31) on which the substrate (W) is to be placed and a placement surface (PF2) of the second placement table (PS7, PS6, PS32) on which the substrate (W) is to be placed,
the method comprising:
a first hand forward step of causing the first hand (39) supporting the first substrate (W) to move forward toward the first placement table (PS2, PS3, PS31);
a first placement step of delivering the first substrate (W) to the first placement table (PS2, PS3, PS31) with the first hand (39) by causing the first hand (39) and the first placement table (PS2, PS3, PS31) to move up and down with respect to each other;
after the first placement step, a first hand backward step of causing the first hand (39) to move backward from the first placement table (PS2, PS3, PS31);
a second hand forward step of causing the second hand (40) to move forward toward the second placement table (PS7, PS6, PS32);
a first reception step of receiving the second substrate (W) from the second placement table (PS7, PS6, PS32) with the second hand (40) by causing the second hand (40) and the second placement table (PS7, PS6, PS32) to move up and down with respect to each other; and
after the first reception step, a second hand backward step of causing the second hand (40) supporting the second substrate (W) to move backward from the second placement table (PS7, PS6, PS32),
wherein the first hand backward step and the second hand forward step are performed in parallel, or the first hand forward step and the second hand backward step are performed in parallel.

7. A substrate conveyance apparatus that conveys a substrate (W), the substrate conveyance apparatus comprising:
a first substrate conveyance robot (TR1, TR3, TR8) including a first hand (39, 57) and a second hand (40, 58) disposed one above the other, the first substrate conveyance robot (TR1, TR3, TR8) being capable of delivering and receiving the substrate (W) to and from a first placement table (PS2, PS3, PS31) and a second placement table (PS7, PS6, PS32) disposed one above the other by moving the first hand (39, 57) and the second hand (40, 58); and
a controller (81),
wherein the first hand (39, 57) is configured to support one first substrate (W) in a horizontal orientation,
the second hand (40, 58) is configured to support one second substrate (W) in the horizontal orientation,
a support interval (JK1, JK2) in an up-down direction between a substrate support surface (SF1) of the first hand (39, 57) and a substrate support surface (SF2) of the second hand (40, 58) is set to coincide with a placement interval (CK1, CK2) in an up-down direction between a placement surface (PF1) of the first placement table (PS2, PS3, PS31) on which the substrate (W) is to be placed and a placement surface (PF2) of the second placement table (PS7, PS6, PS32) on which the substrate (W) is to be placed,
the controller (81):
causes the first hand (39, 57) supporting the first substrate (W) to perform a first hand forward operation (FW1) of moving forward toward the first placement table (PS2, PS3, PS31);
delivers the first substrate (W) to the first placement table (PS2, PS3, PS31) with the first hand (39, 57) by causing the first hand (39, 57) and the first placement table (PS2, PS3, PS31) to move up and down with respect to each other;
thereafter, causes the first hand (39, 57) to perform a first hand backward operation (BW1) of moving backward from the first placement table (PS2, PS3, PS31);
causes the second hand (40, 58) to perform a second hand forward operation (FW2) of moving forward toward the second placement table (PS7, PS6, PS32);
receives the second substrate (W) from the second placement table (PS7, PS6, PS32) with the second hand (40, 58) by causing the second hand (40, 58) and the second placement table (PS7, PS6, PS32) to move up and down with respect to each other; and
thereafter, causes the second hand (40, 58) to perform a second hand backward operation (BW2) of moving backward from the second placement table (PS7, PS6, PS32), and
the controller (81) causes the first hand (39, 57) and the second hand (40, 58) to perform either:
the first hand backward operation (BW1) and the second hand forward operation (FW2) in parallel; or
the first hand forward operation (FW1) and the second hand backward operation (BW2) in parallel.
